**Europäisches Patentamt**

**European Patent Office**

**Office européen des brevets**

(19)

(11) Veröffentlichungsnummer: **0 021 026**
**B1**

(12) **EUROPÄISCHE PATENTSCHRIFT**

(45) Veröffentlichungstag der Patentschrift:
06.04.83

(51) Int. Cl.³: **H 01 L 29/86**

(21) Anmeldenummer: **80102767.3**

(22) Anmeldetag: **20.05.80**

(54) **Halbleiter-Dioden-Anordnung.**

(30) Priorität: **03.07.79 DE 2926805**

(43) Veröffentlichungstag der Anmeldung:
**07.01.81 Patentblatt 81/1**

(45) Bekanntmachung des Hinweises auf die Patenterteilung:
**06.04.83 Patentblatt 83/14**

(84) Benannte Vertragsstaaten:
**AT CH FR GB IT LI NL**

(56) Entgegenhaltungen:

**DE-A-1 514 727**
**FR-A-2 031 421**
**US-A-2 728 034**

(73) Patentinhaber: **Licentia Patent-Verwaltungs-GmbH,**
**Theodor-Stern-Kai 1, D-6000 Frankfurt/Main 70 (DE)**

(72) Erfinder: **Dahlberg, Reinhard, Dr., Innere Bergstrasse 32,**
**D-7101 Flein (DE)**

(74) Vertreter: **Maute, Hans-Jürgen, Dipl.-Ing. et al, Licentia**
**Patent-Verwaltungs-GmbH Theodor-Stern-Kai 1,**
**D-6000 Frankfurt/Main 70 (DE)**

## Halbleiter-Dioden-Anordnung

Die Erfindung betrifft eine monokristalline Halbleiter-Dioden-Anordnung gemäss dem ersten Teil des Anspruchs 1. Eine derartige Anordnung ist aus der DE-A-1 514 724 bekannt.

Monokristalline Halbleiter-Dioden werden heute vorzugsweise aus Silizium, Germanium und III/V-Verbindungen hergestellt. Sie bestehen im Prinzip aus zwei Zonen unterschiedlicher Leitfähigkeit, deren gemeinsame Grenzfläche ein p/n-Übergang ist.

Das Frequenzverhalten einer Diode wird im wesentlichen durch die Kapazität dieses p/n-Überganges und die Bahnwiderstände der Diode bestimmt. Mit der Flächenausdehnung des p/n-Überganges und der Dotierung des p- und n-Bereiches in der Umgebung des p/n-Überganges ist dessen Kapazität (bei der Betriebsspannung Null) in erster Näherung festgelegt. Die elektrische Leistung einer Diode hängt im wesentlichen von der Kühlung und Abführung der Verlustwärme ab. Bei jeder äusseren Kühlung der Diode gibt es eine maximale Leistung, die nicht überschritten werden darf, weil sonst die sogenannte Junction-Temperatur (die Temperatur des p/n-Überganges) eine kritische Grösse (meist 150°C) überschreitet. Da die maximale Leistung auch mit der Diodenfläche gekoppelt ist, hängt auch die Kapazität einer Diode mit ihrer maximalen Leistung zusammen. Je grösser die Verlustleistung einer Diode ist, um so grösser ist im allgemeinen auch ihre Junction-Kapazität und um so niedriger ist im allgemeinen ihre höchste Arbeitsfrequenz.

Die vorliegende Erfindung hat sich die Aufgabe gestellt, die Kopplung von maximaler Verlustleistung mit der Junction-Kapazität einer Diode und die Frequenzbegrenzung bei Dioden grosser Leistung zu reduzieren. Sie geht von der Erkenntnis aus, dass die Leistungsdichte (Watt/cm$^2$) in einer Diode wesentlich erhöht werden könnte, wenn eine Diode wie ein Kontaktwiderstand (ohne Fremdschicht) aufgebaut wäre.

Bekanntlich ist die Temperatur-Erhöhung $\triangle T$ (die sogenannte Übertemperatur) in einem Kontaktwistand (ohne Fremdschicht) gegeben durch die Beziehung $\triangle T = \dfrac{U^2}{8\varrho\lambda}$. Dabei ist U die an dem Kontaktwiderstand liegende Spannung, $\varrho$ der spezifisch elektrische Widerstand und $\lambda$ die spezifische Wärmeleitfähigkeit der Kontaktmaterialien. Der elektrische Widerstand $R_K$ eines Kontaktwiderstandes (ohne Fremdschicht) ist $R_K = \dfrac{\varrho}{2D}$. Dabei ist 2D der Durchmesser des Kontaktes. Die Temperaturerhöhung $\triangle T$ im Kontaktwiderstand $R_K$ als Funktion der Leistungsdichte $P = \dfrac{U^2}{R_k \cdot 4D^2}[\dfrac{Watt}{cm^2}]$ ist $\triangle T = \dfrac{P \cdot D}{4\lambda}$.

Dies bedeutet, dass für ein vorgegebenes $\triangle T$ die Leistungsdichte P im Kontakt um so grösser werden kann, je kleiner der Durchmesser 2D des Kontaktes wird. Diese Betrachtung lässt sich auch auf den Aufbau von Dioden anwenden. Anstatt eine Leistungsdiode mit grosser Fläche zu bauen und mit relativ kleiner Leistungsdichte zu betreiben, kann man eine Diode gleicher Leistung aus vielen sehr kleinflächigen parallel geschalteten Dioden bauen (mit auch in der Summe wesentlich kleinerer Diodenfläche) und mit grosser Leistungsdichte betreiben. Im zweiten Fall erhält man dann eine Diode mit u.a. wesentlich besserem Frequenzverhalten.

Durch die am Schluss der Beschreibung genannte Veröffentlichung (1) ist es bekannt, p/n-Übergänge dadurch zu erzeugen, dass man einen p- und einen n-Kristall aus Silizium oder Germanium bei höherer Temperatur und unter Druck gemeinsam verformt. Sofern der Verformungsgrad nicht grösser als 3% (Versetzungsdichte $< 5 \times 10^6$/cm$^2$) ist, lassen sich nach dieser Methode p/n-Übergänge mit guten elektrischen Eigenschaften erzeugen. Aus der DE-OS-1 514 727 ist gleichfalls eine Diode bekannt, deren pn-Übergang durch plastische Verformung zweier Halbleiterscheiben hergestellt wurde. Aus der US-PS-2 728 034 ist eine wenigstens dreizonige Verstärkeranordnung bekannt, die durch Zusammenfügen zweier Halbleiterscheiben gleichen Leistungstyps und gleichzeitiger Bildung einer Zwischenschicht von entgegengesetztem Leistungstyp zustande kommt. Eine dieser beiden Halbleiterscheiben weist eine Struktur parallel und senkrecht zueinander verlaufender Gräben auf. Allen genannten Veröffentlichungen liegt nicht die bereits erwähnte Aufgabe zugrunde.

Die der vorliegenden Erfindung zugrundeliegende Aufgabe wird bei einer Halbleiteranordnung mit einem durch plastische Verformung erzeugten p/n-Übergang aus einer n-dotierten und einer p-dotierten einkristallinen Halbleiterscheibe dadurch gelöst, dass beide Halbleiterscheiben (1 und 2) auf einer Seite eine Struktur mit parallelen Wällen (3) haben, dass die beiden Halbleiterscheiben mit ihren strukturierten Seiten so zusammengelegt sind, dass die Wälle sich kreuzen und berühren, und dass als Folge der herbeigeführten Kristalldeformation des Halbleitergitters sämtliche Berührungsstellen elektrisch parallel geschaltete p/n-Dioden bilden.

Zur Herstellung der Halbleiter-Dioden-Anordnung werden die Halbleiterscheiben unter Druck und bei erhöhter Temperatur zusammengepresst.

Die Umwandlung der Berührungsstellen in p/n-Übergänge kann im Vakuum, in Wasserstoff- oder auch in Edelgas-Atmosphäre erfolgen. Die Erhebungen in der Struktur können so ausgebildet sein, dass die p/n-Dioden flächengleich werden. Die Struktur mit den Wällen auf den Halbleiterscheiben kann z.B. mit Hilfe eines photolithographischen Prozesses über ein chemisches- oder ein Plasma-Ätzverfahren hergestellt sein.

Das Konstruktionsprinzip der gekreuzten Wälle ist bereits in der Deutschen Offenlegungsschrift P 2 547 262 beschriebenen worden. Es wird in der P 2 547 262 jedoch nur benutzt, um zwischen zwei ungleich temperierten Platten extrem grosse Temperaturgradienten zu erzeugen. Die Herstellung von Halbleiter-Dioden nach diesem Prinzip ist in P 2 547 262 nicht erwähnt.

Wenn jede Halbleiterscheibe in ihrer Struktur N Wälle hat, dann ist die Zahl der p/n-Kontakte zwischen den beiden Halbleiterscheiben $N^2$. Bringt man etwa auf 1 cm² Silizium-Fläche parallele Wälle mit je einer Gratbreite von $5 . 10^{-4}$ cm in einem Abstand von $2 . 10^{-3}$ cm unter, dann kann man $1,6 . 10^5$ parallel geschaltete p/n-Kontakte zwischen einer p- und einer n-Scheibe von je 1 cm² Fläche herstellen. Bei einem sehr gut gekühlten Silizium-Leistungsgleichrichter erreicht der p/n-Übergang eine Übertemperatur von etwa 100° bei einer Leistungsdichte P < $100 \dfrac{Watt}{cm^2}$. Dagegen würde ein einzelner p/n-Kontakt mit einem Durchmesser von $5 . 10^{-4}$ cm ein $\triangle T$ = 100° erst bei einer Leistungsdichte $P = \dfrac{\triangle T . 4\lambda}{D}$ von $4 . 10^5$ Watt/cm² erreichen. Die $1,6 . 10^5$ parallel geschalteten p/n-Kontakte haben eine Gesamtfläche von ca. 0,04 cm². Ihr resultierender Gesamt-Wärmewiderstand ist vernachlässigbar klein gegenüber den anderen Wärmewiderständen der Anordnung.

Mit der Halbleiter-Dioden-Anordnung gemäss der Erfindung lassen sich sehr einfach sowohl symmetrische als auch definiert unsymmetrische p/n-Übergänge dadurch herstellen, dass beide Halbleiterscheiben die gleiche oder eine definiert unterschiedliche Dotierungskonzentration haben. Auch abrupte p/n-Übergänge lassen sich einfach dadurch erzeugen, dass die eine Halbleiterscheibe mit mehr als $5 . 10^{18}$ Störatomen/cm³ dotiert ist, während die andere Scheibe relativ hochohmig ist. Durch Eindiffusion in die hochohmige Seite lässt sich die Sperrspannung erhöhen. Wenn beide Scheiben so hoch dotiert sind, dass sie Störstellen in Entartungskonzentration enthalten, lassen sich Halbleiter-Tunneldioden-Anordnungen herstellen. Zur sicheren Erzielung von Tunnelkontakten können vor dem Umwandeln der Berührungsstellen in p/n-Übergängen in die Oberflächen der beiden Halbleiter-Scheiben Donatoren bzw. Akzeptoren mit Grenzkonzentrationen eindiffundiert werden. Diese Störstellen mit einer Konzentration von z.B. $> 10^{19}$ Atomen/cm³ werden vorzugsweise durch Diffusion oder Implantation in die strukturierten Oberflächenseiten der Halbleiterscheiben eingebracht.

Vor oder nach dem Erzeugen der Strukturen mit den Wällen können auch Epitax-Schichten auf die Halbleiterscheiben aufgebracht werden. Halbleiter-Dioden-Anordnungen gemäss der Erfindung können auch elektrisch parallel und in Serie geschaltet werden.

Da die aktive p/n-Fläche in der Anordnung der Erfindung sehr viel kleiner gemacht werden kann als die äusseren Anschlussdrähte, lassen sich Halbleiter-Dioden-Anordnungen auch als mechanische Druck-Sensoren ausbilden. Auch als Mikrofon kann die Anordnung mit Vorteil ausgebildet werden.

Im folgenden wird die Erfindung anhand von 4 Ausführungsbeispielen erläutert:

Ausführungsbeispiel 1 zeigt einen Leistungsgleichrichter für hohe Frequenzen.

Ausführungsbeispiel 2 zeigt eine Silizium-Tunneldioden-Anordnung.

Ausführungsbeispiel 3 zeigt eine Serienschaltung von Silizium-Tunneldioden-Anordnungen.

Ausführungsbeispiel 4 zeigt eine Halbleiter-Dioden-Anordnung als Druck-Sensor.

*Ausführungsbeispiel 1*

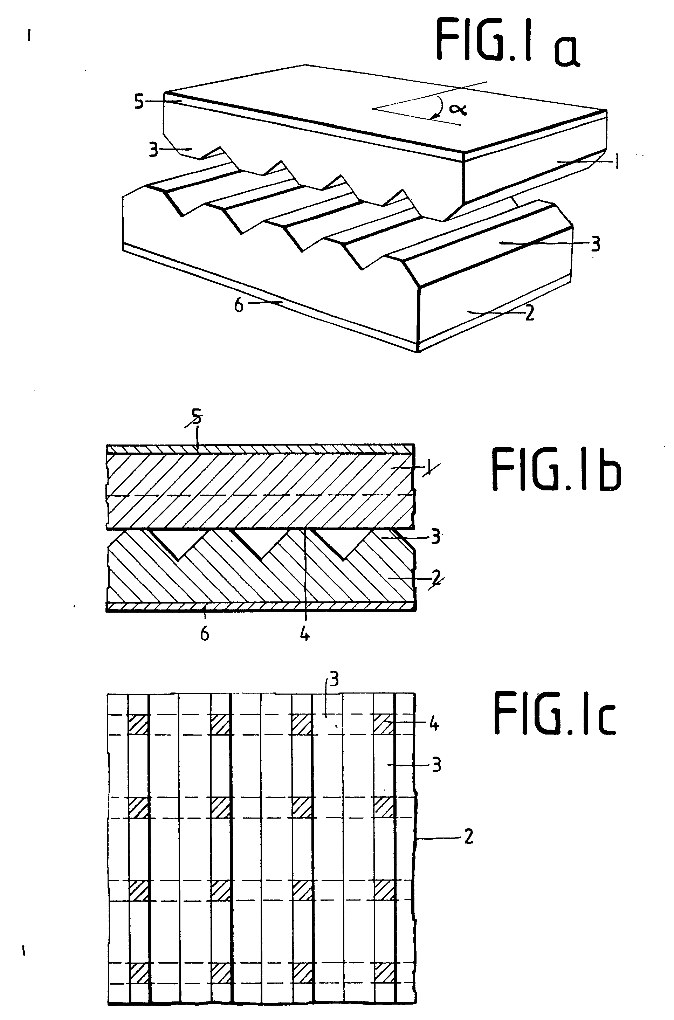

In Fig. 1a ist eine p-Silizium-Scheibe 1 und eine n-Silizium-Scheibe 2 mit je einer Oberflächenstruktur von parallelen Wällen 3 dargestellt. Die p-Scheibe 1 wird (in der Scheiben-Ebene um den Winkel $\propto$ — vorzugsweise $\propto = 90°$ gedreht) auf die Scheibe 2 aufgesetzt, so dass sich die Wälle 3 beider Scheiben kreuzen und berühren. Durch einen Temperaturprozess in einer Wasserstoffatmosphäre sind — wie in den Schnittdarstellungen der Fig. 1b und 1c angedeutet — an den Berührungsstellen der Wälle 3 die p/n-Übergänge 4 entstanden. 5 und 6 sind sperrfreie Metallkontakte an dieser Gleichrichter-Anordnung, die auch im Durchbruch ohne second breakdown und bei höheren Frequenzen betrieben werden kann.

*Ausführungsbeispiel 2*

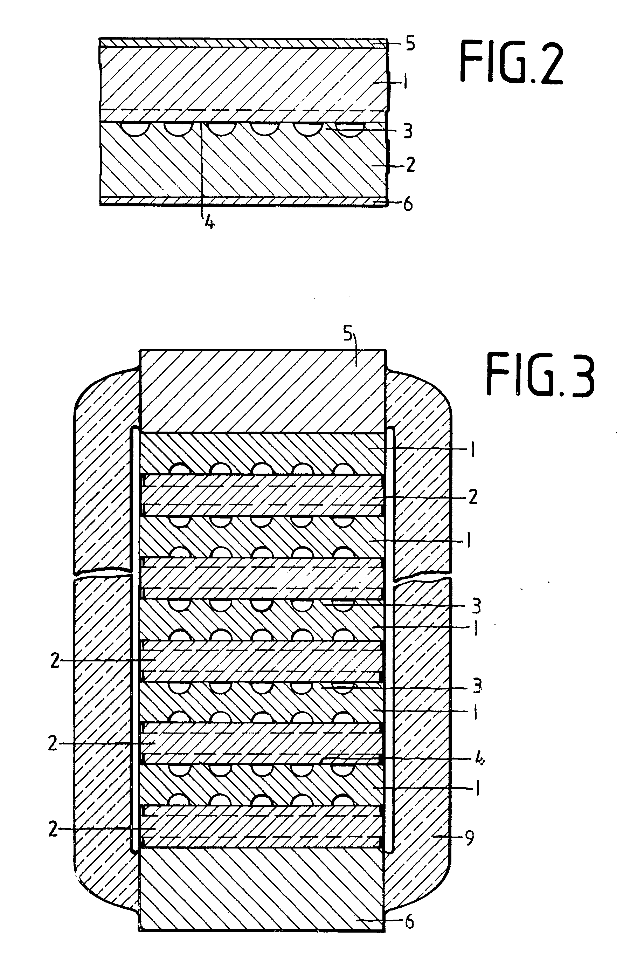

Fig. 2 zeigt im Querschnitt eine p⁺-Silizium-Scheibe 1 und eine n⁺-Silizium-Scheibe 2. Beide Scheiben sind mit ihren strukturierten Seiten zusammengelegt, so dass sich die Wälle 3 überkreuzen und berühren. Die Berührungsstellen sind durch einen Temperaturprozess in Tunnel-Dioden 4 umgewandelt. 5 und 6 sind Metallelektroden an den Scheiben 1 und 2. Die Scheiben 1 und 2 weisen bei der Verwendung als Tunneldioden Entartungskonzentration auf.

*Ausführungsbeispiel 3*

Fig. 3 zeigt eine Tunneldioden-Kaskade gemäss der Erfindung. 1 sind p⁺-Silizium-Scheiben und 2 sind n⁺-Silizium-Scheiben. Beide Scheibenarten 1, 2 haben auf ihren beiden Seiten eine Struktur mit parallelen Wällen 3. Sie sind so zusammengesetzt, dass sich stets die Wälle 3 in der Struktur einer p⁺-Scheibe 1 und einer n⁺-Scheibe 2 überkreuzen. Insgesamt sind beispielsweise 100 p⁺-Scheiben 1 und 100 n⁺-Scheiben 2 von 2,5 cm Durchmesser und $2 . 20^{-2}$ cm Dicke mit einer beidseitigen Struktur von parallelen Wällen 3 zusammengesetzt und mit Hilfe eines Temperaturprozesses zu einer Tunneldioden-Kaskade vereinigt. 5 und 6 sind die Metall-Anschlüsse dieser Kaskade. 4 sind die p⁺/n⁺-Übergänge. 9 ist das Glasgehäuse der Kaskade, die eine Länge von 5 cm und einen Durchmesser von 4 cm hat. Der Bereich des negativen differentiellen Widerstandes erstreckt sich über 20 Volt.

*Ausführungsbeispiel 4*

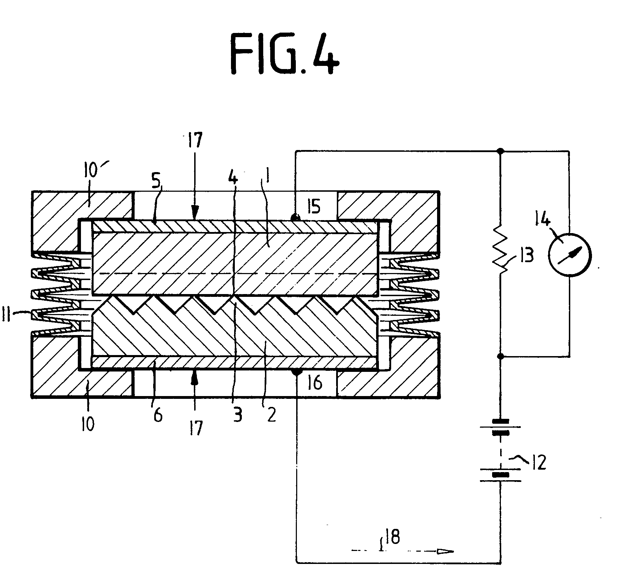

Fig. 4 zeigt schematisch die Halbleiter-Dioden-Anordnung als Druck-Sensor. 1 ist eine p-Silizium-Scheibe und 2 ist eine n-Silizium-Scheibe. Beide Silizium-Scheiben haben sperrfreie Metall-Kontakte 5 und 6. Über eine Strukturätzung sind in beide Scheiben die parallelen Wälle 3 eingeätzt worden. Die sich überkreuzenden Wälle 3 bilden an den Berührungsstellen p/n-Übergänge mit Durchmessern von $1 . 10^{-4}$ cm. An den Scheiben 1 und 2 liegt über die Anschlüsse 15 und 16 sowie den Vorwiderstand 13 die Spannung der Batterie 12, welche über den Widerstand 13 und die gesperrten p/n-Übergänge 4 den Strom 18 erzeugt. Der mechanische Druck 17 verändert sehr empfindlich den Sperrstrom 18 über die p/n-Übergänge 4. 10 ist ein Keramik-Gehäuse und 11 ist ein elastisches Glied im Gehäuse 10. Die Änderung des Spannungsabfalls als Folge der Schwankung des Stromes 18 im Widerstand 13 wird mit dem Messgerät 14 gemessen.

(1) S. Schäfer
«Herstellung von p-n-Übergängen durch gemeinsame plastische Verformung von p- und n-dotiertem Germanium»
Solid-State-Electronics, *11*, 675-681 (1968)

## Patentansprüche

1. Halbleiter-Dioden-Anordnung mit einem durch plastische Verformung erzeugten p/n-Übergang, aus einer n-dotierten (1) und einer p-dotierten (2) einkristallinen Halbleiterscheibe, dadurch gekennzeichnet, dass beide Halbleiterscheiben (1 und 2) auf einer Seite eine Struktur mit parallelen Wällen (3) haben, dass die beiden Halbleiterscheiben mit ihren strukturierten Seiten so zusammengelegt sind, dass die Wälle sich kreuzen und berühren, und dass als Folge der herbeigeführten Kristalldeformation des Halbleitergitters sämtliche Berührungsstellen elektrisch parallel geschaltete p/n-Dioden bilden.

2. Halbleiter-Dioden-Anordnung nach Anspruch 1, dadurch gekennzeichnet, dass die elektrisch parallel geschalteten p/n-Dioden flächengleich sind.

3. Halbleiter-Dioden-Anordnung nach Anspruch 1 oder 2, dadurch gekennzeichnet, dass die Struktur auf den Halbleiterscheiben (1 und 2) mit Hilfe eines chemischen oder Plasma-Ätzverfahrens hergestellt ist.

4. Halbleiter-Dioden-Anordnung nach einem der vorhergehenden Ansprüche, dadurch gekennzeichnet, dass auf der n-dotierten (1) und der p-dotierten Halbleiterscheibe (2) eine vor oder nach dem Erzeugen der Struktur hergestellte Epitaxie-Schicht angeordnet ist.

5. Halbleiter-Dioden-Anordnung nach einem der vorhergehenden Ansprüche, dadurch gekennzeichnet, dass die n-dotierte und die p-dotierte Halbleiterscheibe (1 und 2) auf ihren nichtstrukturierten Seiten mit einem ohmschen Kontakt versehen sind.

6. Halbleiter-Dioden-Anordnung nach einem der vorhergehenden Ansprüche, dadurch gekennzeichnet, dass die n-dotierte Scheibe (1) die gleiche Konzentration an Donatoren wie die p-dotierte Scheibe (2) an Akzeptoren enthält.

7. Halbleiter-Dioden-Anordnung nach einem der vorhergehenden Ansprüche, dadurch gekennzeichnet, dass entweder die n-Scheibe (1) oder die p-Scheibe (2) eine Störstellenkonzentration hat, die grösser als $5 \times 10^{18}$ Atome/cm$^3$ ist.

8. Halbleiter-Dioden-Anordnung nach einem der vorhergehenden Ansprüche, dadurch gekennzeichnet, dass die beiden Halbleiterscheiben (1 und 2) mit Entartungskonzentrationen n$^+$ und p$^+$ dotiert sind, so dass ein Array von Tunneldioden entsteht.

9. Halbleiter-Dioden-Anordnung nach Anspruch 8, dadurch gekennzeichnet, dass in die strukturierte Seite der n$^+$-dotierten Scheibe (1), mit Hilfe eines eines Diffusions- oder Implantationsprozesses Donatoren mit einer Oberflächenkonzentration $> 10^{19}$ Atome/cm$^3$ und die strukturierte Seite der in Serie geschaltet sind.

10. Halbleiter-Dioden-Anordnung nach einem der vorhergehenden Ansprüche, dadurch gekennzeichnet, dass mehrere Halbleiter-Dioden-Anordnungen aus je zwei Halbleiterscheiben elektrisch parallel und in serie geschaltet sind.

11. Halbleiter-Dioden-Anordnung nach einem der vorhergehenden Ansprüche, gekennzeichnet durch ihre Verwendung als Druck-Sensor.

12. Halbleiter-Dioden-Anordnung nach einem der vorhergehenden Ansprüche, gekennzeichnet durch ihre Verwendung als Mikrofon.

## Claims

1. Semiconductor diode arrangement with a p/n transition produced by plastic deformation, said arrangement comprising an n-doped (1) and a p-doped (2) single-crystalline semiconductor disk, characterized in that both semiconductor disks (1 and 2) comprise on one of their sides a structure with parallel walls (3), in that both semiconductor disks are combined at their structured sides such that the walls cross and contact each other, and in that as a result of the crystal deformation occurring in the semiconductor grid all of the points of contact form p/n diodes which are electrically connected in parallel.

2. Semiconductor diode arrangement as defined in claim 1, characterized in that the p/n diodes which are electrically connected in parallel are equal in area.

3. Semiconductor diode arrangement as defined in claim 1 or 2, characterized in that the structure on the semiconductor disks (1 and 2) is produced by a chemical or plasma etching process.

4. Semiconductor diode arrangement as defined in one of the preceding claims, characterized in that an epitaxy layer produced before or after the formation of the structure is disposed on the n-doped (1) and the p-doped (2) semiconductor disk.

5. Semiconductor diode arrangement as defined in one of the preceding claims, characterized in that the n-doped and the p-doped semiconductor disks (1 and 2) are provided with an ohmic contact on their non-structured sides.

6. Semiconductor diode arrangement as defined in one of the preceding claims, characterized in that the n-doped disk (1) contains the same concentration of donors as the p-doped disk (2) acceptors.

7. Semiconductor diode arrangement as defined in one of the preceding claims, characterized in that either the n-disk (1) or the p-disk (2) has an impurity concentration which is larger than $5 \times 10^{18}$ atoms/cm$^3$.

8. Semiconductor diode arrangement as defined in one of the preceding claims, characterized in that both semiconductor disks (1 and 2) are doped with degeneration concentrations $n^+$ and $p^+$ so as to produce an array of tunnel diodes.

9. Semiconductor diode arrangement as defined in claim 8, characterized in that donors with a surface concentration $> 10^{19}$ atoms/cm$^3$ are introduced into the structured side of the $n^+$-doped disk (1) by a diffusion or implantation process and acceptors with a surface concentration $> 10^{19}$ atoms/cm$^3$ into the structured side of the $p^+$-disk (2).

10. Semiconductor diode arrangement as defined in one of the preceding claims, characterized in that several semiconductor diode arrangements each comprising two semiconductor disks are electrically connected in parallel and in series.

11. Semiconductor diode arrangement as defined in one of the preceding claims, characterized by its use as a pressure sensor.

12. Semiconductor diode arrangement as defined in one of the preceding claims, characterized by its use as a microphone.

**Revendications**

1. Réseau de diodes semiconductrices comportant une jonction p/n produite par déformation plastique d'une plaquette semiconductrice monocristalline (1) à dopage n et d'une plaquette semiconductrice monocristalline (2) à dopage p, ledit réseau étant caractérisé en ce que les deux plaquettes semiconductrices (1 et 2) présentent chacune sur une face une structure de protubérances (3) parallèles; les deux plaquettes semiconductrices sont assemblées par leurs faces structurées de façon que les protubérances se croisent et viennent en contact; et tous les points de contact forment des diodes p/n couplées électriquement en parallèle par la déformation résultante du réseau cristallin semiconducteur.

2. Réseau de diodes semiconductrices selon revendication 1, caractérisé en ce que les diodes p/n couplées électriquement en parallèle présentent une même surface.

3. Réseau de diodes semiconductrices selon une des revendications 1 ou 2, caractérisé en ce que la structure est produite sur les plaquettes semiconductrices (1 et 2) par un procédé de gravure chimique ou à plasma.

4. Réseau de diodes semiconductrices selon une quelconque des revendications 1 à 3, caractérisé par le dépôt sur les plaquettes semiconductrices à dopage n (1) et à dopage p (2) d'une couche épitaxiale produite avant ou après la production de la structure.

5. Réseau de diodes semiconductrices selon une quelconque des revendications 1 à 4, caractérisé en ce que les plaquettes semiconductrices à dopage n (1) et dopage p (2) sont munies d'un contact ohmique sur leur face non structurée.

6. Réseau de diodes semiconductrices selon une quelconque des revendications 1 à 5, caractérisé en ce que la plaquette à dopage n (1) reçoit des donneurs en concentration égale à celle des accepteurs de la plaquette à dopage p (2).

7. Réseau de diodes semiconductrices selon une quelconque des revendications 1 à 6, caractérisé en ce que la plaquette n (1) ou la plaquette p (2) présente une concentration en impurité supérieure à $5.10^{18}$ atomes/cm$^3$.

8. Réseau de diodes semiconductrices selon une quelconque des revendications 1 à 7, caractérisé en ce que les deux plaquettes semiconductrices (1 et 2) sont dopées à des concentrations de dégénérescence $n^+$ et $p^+$, de façon à produire un réseau de diodes tinnel.

9. Réseau de diodes semiconductrices selon revendication 8, caractérisé par l'introduction, par diffusion ou implantation, dans la face structurée de la plaquette à dopage $n^+$ (1) de donneurs à une concentration superficielle $> 10^{19}$ atomes/cm$^3$, et dans la face structurée de la plaquette $p^+$ (2) d'accepteurs à une concentration superficielle $> 10^{19}$ atomes/cm$^3$.

10. Réseau de diodes semiconductrices selon une quelconque des revendications 1 à 9, caractérisé par le couplage électrique en parallèle et en série de plusieurs réseaux de diodes semiconductrices comportant chacun deux plaquettes semiconductrices.

11. Réseau de diodes semiconductrices selon une quelconque des revendications 1 à 10, caractérisé par son utilisation comme sonde de pression.

12. Réseau de diodes semiconductrices selon une quelconque des revendications 1 à 10, caractérisé par son utilisation comme microphone.

FIG.1a

FIG.1b

FIG.1c

FIG.2

FIG.3

# FIG.4